# EUROPEAN PATENT SPECIFICATION

(11) **EP 4 403 942 B1**
(45) Date of publication and mention of the grant of the patent: **14.10.2026**
(21) Application number: 23740510.5
(22) Date of filing: 13.01.2023
(51) Int. Cl.: G01R 31/367, G01R 31/392, G01R 31/36, G01R 31/396, G01R 19/00, G01R 31/3828

(54) **BATTERY LIFE PREDICTION APPARATUS AND OPERATING METHOD THEREOF**
VORRICHTUNG ZUR VORHERSAGE DER BATTERIELEBENSDAUER UND BETRIEBSVERFAHREN DAFÜR
APPAREIL DE PRÉDICTION DE DURÉE DE VIE D'UNE BATTERIE, ET SON PROCÉDÉ DE FONCTIONNEMENT

(30) Priority: 17.01.2022 KR 20220006879
(43) Date of publication of application: 24.07.2024
(73) Proprietor: LG Energy Solution, Ltd., Seoul 07335 (KR)
(72) Inventor: CHOI, Jeong Hyeon, Daejeon 34122 (KR); JEONG, Yu Na, Daejeon 34122 (KR)
(74) Representative: Plasseraud IP
(86) International application number: PCT/KR2023/000681
(87) International publication number: WO 2023/136667

(56) References cited:
- KR-A- 20110 084 633
- KR-A- 20150 054 162
- KR-A- 20160 090 226
- KR-A- 20170 058 165
- KR-A- 20170 058 165
- KR-B1- 100 911 317
- KR-B1- 100 911 317
- KR-B1- 101 509 001
- KR-B1- 102 035 678
- KR-B1- 102 101 002
- US-A1- 2012 262 126
- US-A1- 2015 120 225
- US-A1- 2016 209 472
- US-A1- 2020 386 819
- US-B2- 9 643 508

## Description

### [TECHNICAL FIELD]

### TECHNICAL FIELD

Embodiments disclosed herein relate to a battery life prediction apparatus and an operating method thereof. The documents US 2015/120225, and US 2016/209472 are known, but present limitations. In particular, US 2015/120225 relates to an apparatus and method for determining degradation of a high-voltage vehicle battery, and more particularly, to an apparatus and method for estimating a state of health (SOH) of a high-voltage vehicle battery pack, and US 2016/209472 relates to a method and apparatus for estimating a battery life, that relies on estimating first status information of a battery based on battery information acquired from the battery, estimating second status information of the battery using a partial cycle model corresponding to a battery degradation pattern for a partial cycle, and calculating the battery life based on a comparison between the first status information and the second status information. However, those two documents rely on life prediction functions that is modeled in a controlled environment and may not provide accurate prediction in real environments.

### [BACKGROUND ART]

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

Meanwhile, an energy storage system (ESS) is a device for storing produced electricity in a storage device such as a battery and supplying power when required, to improve the efficiency of power usage. Generally, there are various methods for predicting the life of the energy storage system, and various studies have been conducted to improve the accuracy of prediction.

### [DISCLOSURE]

### [TECHNICAL PROBLEM]

Embodiments disclosed herein aim to provide a battery life prediction apparatus and an operating method thereof to improve the accuracy of battery life prediction.

Technical problems of the embodiments disclosed herein are not limited to the above-described technical problems, and other unmentioned technical problems would be clearly understood by one of ordinary skill in the art from the following description.

### [TECHNICAL SOLUTION]

The object of the invention is achieved by the subject-matter of the independent claims. Advantageous embodiments are defined in the dependent claims. Further examples are provided for facilitating the understanding of the invention.

### [ADVANTAGEOUS EFFECTS]

A battery life prediction apparatus and an operating method thereof according to an embodiment disclosed herein may improve the accuracy of battery life prediction.

Moreover, the battery life prediction apparatus and the operating method thereof according to an embodiment disclosed herein may manage a life prediction function for battery life prediction.

### [DESCRIPTION OF DRAWINGS]

FIG. 1 is a view showing a battery system according to an embodiment disclosed herein.
FIG. 2 shows a battery life prediction apparatus according to an embodiment disclosed herein.
FIG. 3 is a view for describing an operation of a battery life prediction apparatus, according to an embodiment disclosed herein.
FIGS. 4 and 5 are flowcharts showing an operating method of a battery life prediction apparatus according to an embodiment disclosed herein.
FIG. 6 illustrates a computing system that executes an operating method of a battery life prediction apparatus according to an embodiment disclosed herein.

### [MODE FOR INVENTION]

Hereinafter, embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present application.

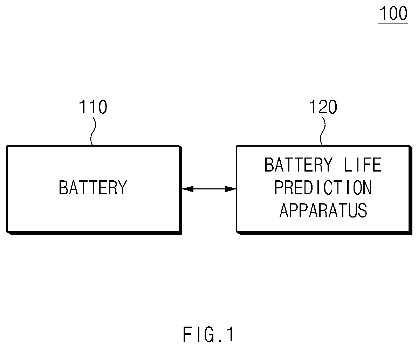

FIG. 1 is a view showing a battery system according to an embodiment disclosed herein.

Referring to FIG. 1, a battery system 100 may include a battery 110 and a battery life prediction apparatus 120.

The battery 110 may store energy and supply the stored energy to a load (not shown). To this end, the battery 110 may be electrically connected to the load. Herein, the load may include an electrical, electronic, or mechanical device that operates by receiving power from the battery 110 including a plurality of battery cells.

According to an embodiment, the battery 110 may include an energy storage system. Moreover, for example, the battery 110 may include a battery pack and/or a battery module which may include n (n is a natural number of 2 or greater) battery cells. Each battery cell may be a lithium ion (Li-ion) battery, a Li-ion polymer battery, a nickelcadmium (Ni-Cd) battery, a nickel hydrogen (Ni-MH) battery, etc., and is not limited thereto.

The battery life prediction apparatus 120 may manage an operation and/or a state of the battery 110. According to an embodiment, the battery life prediction apparatus 120 may predict the life of the battery 110. Herein, the life of the battery 110 may include the remaining life, and may be understood as meanings such as a degree of aging, a degree of deterioration, a state of health (SoH), etc.

The battery life prediction apparatus 120 may obtain operational data of the battery 110. According to an embodiment, the operational data may include log data of the battery 110, for example, measurement values such as a voltage, a current, a temperature, etc., and an SoC, a CP-rate, an operating time, etc., related to use of the battery 110. According to an embodiment, the battery life prediction apparatus 120 may obtain the operational data of the battery 110 from the battery 110 wiredly or via a wireless communication network or obtain the operational data of the battery 110 from another external device.

The battery life prediction apparatus 120 may predict the life of the battery 110 based on the operational data of the battery 110. According to an embodiment, the battery life prediction apparatus 120 may predict the life of the battery 110 based on a current integration method to generate a first result. Herein, the current integration method may be understood as a life prediction method based on Equation 1 provided below, in which a state of health (SoH) indicates the remaining life of the battery 110, △SOC indicates a charge amount difference based on charge/discharge, ∫ i dt indicates a current integration value, and nominal capacity indicates a nominal capacity of the battery 110. [Equation 1] $SOH = \frac{\frac{\int idt}{ΔSOC}}{Nominal Capacity}$

According to an embodiment, the battery life prediction apparatus 120 may predict the life of the battery 110 based on a life prediction function to generate a second result. Herein, the life prediction function may include an equation modeled based on data measured experimentally in various environments for battery life prediction.

The battery life prediction apparatus 120 may manage the life prediction function based on the first and second results of predicting the life of the battery 110. According to an embodiment, the battery life prediction apparatus 120 may correct the life prediction function such that the second result has a value corresponding to the first result or a difference between the second result and the first result is less than a reference value.

The battery life prediction apparatus 120 may predict the life of the battery 110 based on the corrected life prediction function. Thus, the accuracy of life prediction of the battery 110 may be improved.

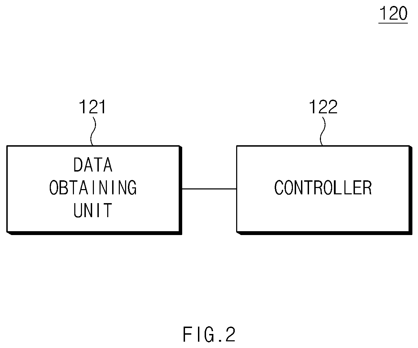

That is, the life prediction function is an equation modeled based on stable conditions such as a laboratory environment, such that the second result of predicting the life of the battery 110 based on the life prediction function under actual use environment conditions of the battery 110 may have low accuracy. Thus, by correcting parameter values of the life prediction function by using the first result based on the current integration method having relatively high life prediction accuracy, the life prediction accuracy may be improved. This will be described in more detail with reference to FIGS. 2 through 5 below.

Meanwhile, according to an embodiment, the battery life prediction apparatus 120 may include a battery management system (BMS). In this case, the battery life prediction apparatus 120 may manage and/or control a state and/or an operation of the battery 110. For example, the battery life prediction apparatus 120 may manage and/or control the states and/or operations of a plurality of battery cells included in the battery 110. The battery life prediction apparatus 120 may manage charge and/or discharge of the battery 110.

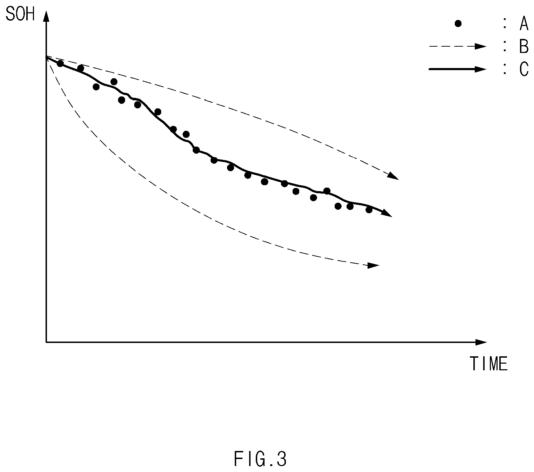

FIG. 2 shows a battery life prediction apparatus according to an embodiment disclosed herein. FIG. 3 is a view for describing an operation of a battery life prediction apparatus, according to an embodiment disclosed herein.

First, referring to FIG. 2, the battery life prediction apparatus 120 may include a data obtaining unit 121 and a controller 122.

The data obtaining unit 121 may obtain operational data from the battery 110. According to an embodiment, the operational data may include log data of the battery 110, and include measurement values such as a voltage, a current, a temperature, etc., and an SoC, a CP-rate, an operating time, etc., related to use of the battery 110. The data obtaining unit 121 may obtain operational data from the battery 110 in real time. The data obtaining unit 121 may obtain the operational data wiredly (via a wired connection) or via the wireless communication network, and deliver the obtained operational data to the controller 122.

The controller 122 may predict the life of the battery 110 by using the operational data. According to an embodiment, the controller 122 may predict the life of the battery 110 based on the current integration method by using the operational data to generate the first result.

The controller 122 may predict the life of the battery 110 based on the life prediction function by using the operational data to generate the second result. For example, the controller 122 may analyze a use pattern of the battery 110 by using the operational data and predict the life of the battery 110 based on the life prediction function corresponding to the use pattern to generate the second result. The controller 122 may analyze the use pattern of the battery 110 daily and predict the life of the battery 110 daily based on the analyzed use pattern.

The controller 122 may manage the life prediction function based on the first and second results. According to an embodiment, the life prediction function may include an equation including at least one factors for predicting the life of the battery and at least one parameter that are coefficients of the respective factors, and for example, the at least one factors may include, but not limited to, an SoC, a CP-rate, a temperature, a use time, etc.

According to an embodiment, the controller 122 may manage the life prediction function such that the second result has a value corresponding to the first result. According to an embodiment, the controller 122 may manage the life prediction function such that a difference between the second result and the first result is less than a reference value. For example, the reference value may be 0.5 % point, but this is merely an example and may change with various environments and conditions.

According to an embodiment, the controller 122 may compare the first result with the second result. The controller 122 may manage the life prediction function when the difference between the first result and the second result is equal to or greater than the reference value. For example, the controller 122 may correct a value of at least one parameter of the life prediction function when the difference between the first result and the second result is equal to or greater than the reference value. Herein, at least one parameter may mean a coefficient of factors (e.g., an SoC, a CP-rate, a temperature, etc.) of the life prediction function.

For example, the controller 122 may obtain a value of at least one parameter of the life prediction function for generating the second result corresponding to the first result. In addition, for example, the controller 122 may obtain the value of the at least one parameter of the life prediction function for generating the second result for causing the difference between the second result and the first result to be less than the reference value (or for minimizing the difference). According to an embodiment, the controller 122 may find the value of the at least one parameter by using a generalized reduced gradient (GRG) nonlinear engine. The controller 122 may repeatedly manage and/or correct the life prediction function until the difference between the first result and the second result is less than the reference value.

The controller 122 may update the life prediction function when the difference between the first result and the second result is less than the reference value. For example, the controller 122 may update the value of the at least one parameter of the life prediction function.

Thus, the controller 122 may accurately predict the life of the battery 110 based on the updated life prediction function.

That is, referring to FIG. 3, the controller 122 may correct the life prediction function to generate the second result that minimizes a difference between a first result A and a second result B, and predict C the life of the battery 110 based on the corrected life prediction function, thereby improving the accuracy of life prediction.

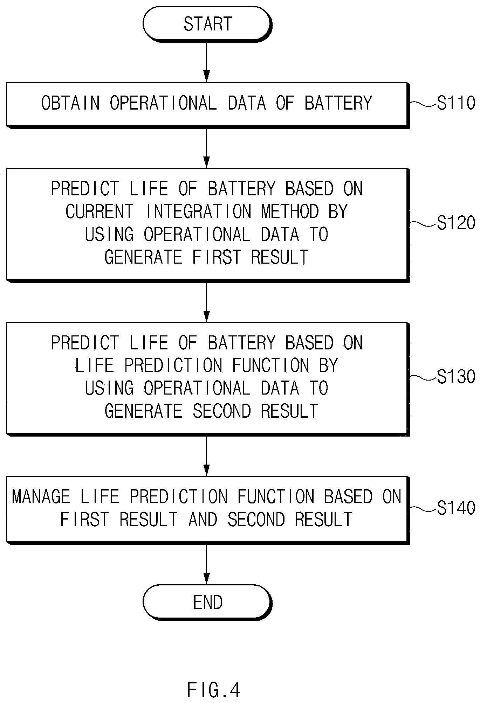

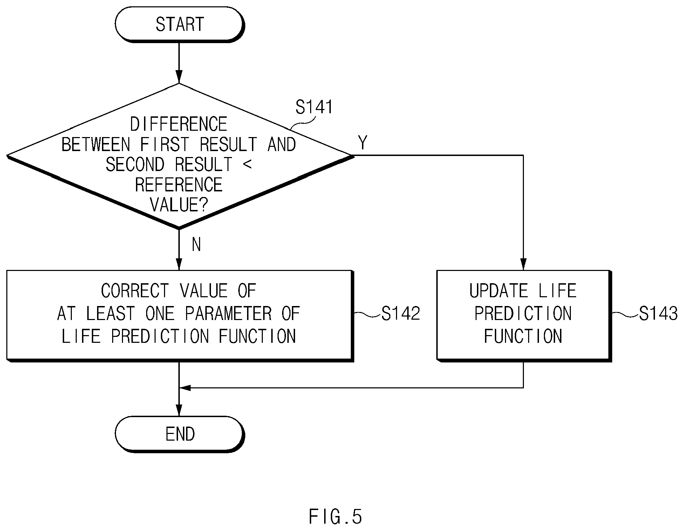

FIGS. 4 and 5 are flowcharts showing an operating method of a battery life prediction apparatus according to an embodiment disclosed herein.

Referring to FIG. 4, an operating method of a battery life prediction apparatus according to an embodiment disclosed herein may include operation S110 of obtaining operational data of a battery, operation S120 of predicting a life of the battery based on a current integration method by using the operational data to generate a first result, operation S130 of predicting the life of the battery based on the life prediction function by using the operational data to generate a second result, and operation S140 of managing the life prediction function based on the first result and the second result.

Hereinbelow, operations S110 through S140 will be described in detail with reference to FIG. 2.

In operation S110, the data obtaining unit 121 may obtain operational data from the battery 110. According to an embodiment, the operational data may include log data of the battery 110, and include measurement values such as a voltage, a current, a temperature, etc., and an SoC, a CP-rate, an operating time, etc., related to use of the battery 110.

In operation S120, the controller 122 may predict the life of the battery 110 based on the current integration method by using the operational data to generate the first result.

In operation S130, the controller 122 may predict the life of the battery 110 based on the life prediction function by using the operational data to generate the second result. According to an embodiment, operation S130 may be performed simultaneously with operation S120.

In operation S140, the controller 122 may manage the life prediction function based on the first and second results.

Referring to FIG. 5, operation S140 may include operation S141 of comparing the difference between the first result and the second result with the reference value, operation S142 of correcting a value of at least one parameter of the life prediction function, and operation S143 of updating the life prediction function.

In operation S141, the controller 122 may determine whether the difference between the first result and the second result is less than the reference value. According to an embodiment, operation S142 may be performed when the difference between the first result and the second result is equal to or greater than the reference value, and operation S143 may be performed when the difference between the first result and the second result is less than the reference value.

In operation S142, the controller 122 may manage the life prediction function when the difference between the first result and the second result is equal to or greater than the reference value. For example, the controller 122 may correct a value of at least one parameter of the life prediction function when the difference between the first result and the second result is equal to or greater than the reference value.

For example, the controller 122 may obtain a value of at least one parameter of the life prediction function for generating the second result corresponding to the first result. In addition, for example, the controller 122 may obtain the value of the at least one parameter of the life prediction function for generating the second result for causing the difference between the second result and the first result to be less than the reference value (or for minimizing the difference).

In operation S143, the controller 122 may update the life prediction function when the difference between the first result and the second result is less than the reference value. For example, the controller 122 may update the value of the at least one parameter of the life prediction function.

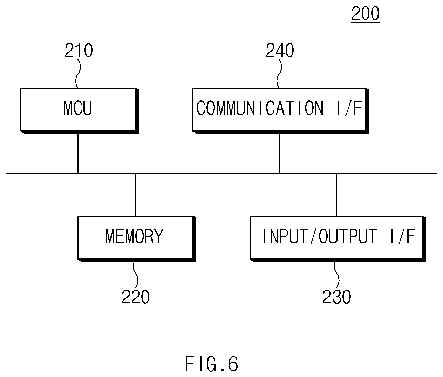

FIG. 6 illustrates a computing system that executes an operating method of a battery life prediction apparatus according to an embodiment disclosed herein.

Referring to FIG. 6, a computing system 200 according to an embodiment disclosed herein may include a microcontroller (MCU) 210, a memory 220, an input/output I/F (interface) 230, and a communication I/F 240.

The MCU 210 may be a processor that executes various programs stored in the memory 220, processes various operational data including current, voltage, temperature, SoC, etc., of the battery 110 through these programs, executes functions of the battery life prediction apparatus 120 described above with reference to FIGS. 1 to 3, or executes the operating method of the battery life prediction apparatus described with reference to FIGS. 4 and 5.

The memory 220 may store various programs regarding life prediction of the battery 110. Moreover, the memory 220 may store various operational data such as SoC data, SoH data, etc., of the battery 110.

The memory 220 may be provided in plural, depending on a need. The memory 220 may be volatile memory or non-volatile memory. For the memory 220 as the volatile memory, random access memory (RAM), dynamic RAM (DRAM), static RAM (SRAM), etc., may be used. For the memory 220 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 220 are merely examples and are not limited thereto.

The input/output I/F 230 may provide an interface for transmitting and receiving data by connecting an input device (not shown) such as a keyboard, a mouse, a touch panel, etc., and an output device such as a display (not shown), etc., to the MCU 210.

The communication I/F 240, which is a component capable of transmitting and receiving various data to and from a server, may be various devices capable of supporting wired or wireless communication. For example, a program or various data, etc., for life prediction of the battery 110 may be transmitted and received to and from a separately provided external server through the communication I/F 240.

As such, the operating method of the battery life prediction apparatus according to an embodiment disclosed herein may be recorded in the memory 220 and executed by the MCU 210.

## Claims

1. A battery life prediction apparatus (120) comprising:
a data obtaining unit (121) configured to obtain operational data of a battery (110); and
a controller (122) configured to:
predict a life of the battery based on a current integration method by using the operational data to generate a first result,
predict the life of the battery based on a life prediction function by using the operational data to generate a second result, and
manage the life prediction function based on the first result and the second result;
said battery life prediction apparatus being **characterized in that** the controller is further configured, for managing the life prediction function, to correct a value of at least any one parameter of the life prediction function so that the second result has a value corresponding to the first result, said at least one parameter comprising a coefficient of at least any one of a state of charge (SoC), a constant power rate (CP-rate), and a temperature of the life prediction function.

2. The battery life prediction apparatus of claim 1, wherein the controller is further configured to correct said value so that a difference between the second result and the first result is less than a reference value.

3. The battery life prediction apparatus of claim 1, wherein the controller is further configured to update the life prediction function by using the value of the at least one of a state of charge (SoC), a constant power rate (CP-rate), and a temperature of the life prediction function when a difference between the second result and the first result is less than a reference value.

4. The battery life prediction apparatus of claim 1, wherein the controller is further configured to:
generate the first result and the second result based on the operational data obtained daily, and
manage the life prediction function based on the first result and the second result obtained daily.

5. An operating method of a battery life prediction apparatus, the operating method comprising:
Obtaining (S110) operational data of a battery;
Predicting (S120) a life of the battery based on a current integration method by using the operational data to generate a first result;
Predicting (S130) the life of the battery based on a life prediction function by using the operational data to generate a second result; and
Managing (S140) the life prediction function based on the first result and the second result;
Said operating method being **characterized in that** managing the life prediction function comprises Correcting (S142) a value of at least any one parameter of the life prediction function so that the second result has a value corresponding to the first result, said at least one parameter comprising a coefficient of at least any one of a state of charge (SoC), a constant power rate (CP-rate), and a temperature of the life prediction function.

6. The operating method of claim 5, wherein the managing of the life prediction function based on the first result and the second result comprises:
Comparing (S141) a difference between the second result and the first result with a reference value..

7. The operating method of claim 6, further comprising updating (S143) the life prediction function, based on the result of comparing the difference with the reference value.

## Patentansprüche

1. Vorrichtung zur Vorhersage der Batterielebensdauer (120), umfassend:
eine Datenerhaltungseinheit (121), die konfiguriert ist, um Betriebsdaten einer Batterie (110) zu erhalten; und
eine Steuerung (122), die konfiguriert ist, um:
eine Lebensdauer der Batterie basierend auf einem Stromintegrationsverfahren unter Verwendung der Betriebsdaten vorherzusagen, um ein erstes Ergebnis zu erzeugen,
die Lebensdauer der Batterie basierend auf einer Lebensdauervorhersagefunktion unter Verwendung der Betriebsdaten vorherzusagen, um ein zweites Ergebnis zu erzeugen, und
die Lebensdauervorhersagefunktion basierend auf dem ersten Ergebnis und dem zweiten Ergebnis zu verwalten;
wobei die Vorrichtung zur Vorhersage der Batterielebensdauer **dadurch gekennzeichnet ist, dass** die Steuerung ferner konfiguriert ist, um zum Verwalten der Lebensdauervorhersagefunktion einen Wert von mindestens einem beliebigen Parameter der Lebensdauervorhersagefunktion zu korrigieren, sodass das zweite Ergebnis einen Wert aufweist, der dem ersten Ergebnis entspricht, wobei der mindestens eine Parameter einen Koeffizienten von mindestens einem beliebigen von einem Ladezustand (SoC), einer konstanten Leistungsrate (CP-Rate) und einer Temperatur der Lebensdauervorhersagefunktion umfasst.

2. Vorrichtung zur Vorhersage der Batterielebensdauer nach Anspruch 1, wobei die Steuerung ferner konfiguriert ist, um den Wert so zu korrigieren, dass eine Differenz zwischen dem zweiten Ergebnis und dem ersten Ergebnis kleiner als ein Referenzwert ist.

3. Vorrichtung zur Vorhersage der Batterielebensdauer nach Anspruch 1, wobei die Steuerung ferner konfiguriert ist, um die Lebensdauervorhersagefunktion unter Verwendung des Wertes von dem mindestens einen von einem Ladezustand (SoC), einer konstanten Leistungsrate (CP-Rate) und einer Temperatur der Lebensdauervorhersagefunktion zu aktualisieren, wenn eine Differenz zwischen dem zweiten Ergebnis und dem ersten Ergebnis kleiner als ein Referenzwert ist.

4. Vorrichtung zur Vorhersage der Batterielebensdauer nach Anspruch 1, wobei die Steuerung ferner konfiguriert ist, um:
das erste Ergebnis und das zweite Ergebnis basierend auf den täglich erhaltenen Betriebsdaten zu erzeugen, und
die Lebensdauervorhersagefunktion basierend auf dem täglich erhaltenen ersten und zweiten Ergebnis zu verwalten.

5. Betriebsverfahren einer Vorrichtung zur Vorhersage der Batterielebensdauer, wobei das Betriebsverfahren umfasst:
Erhalten (S110) von Betriebsdaten einer Batterie;
Vorhersagen (S120) einer Lebensdauer der Batterie basierend auf einem Stromintegrationsverfahren unter Verwendung der Betriebsdaten, um ein erstes Ergebnis zu erzeugen;
Vorhersagen (S130) der Lebensdauer der Batterie basierend auf einer Lebensdauervorhersagefunktion unter Verwendung der Betriebsdaten, um ein zweites Ergebnis zu erzeugen; und
Verwalten (S140) der Lebensdauervorhersagefunktion basierend auf dem ersten Ergebnis und dem zweiten Ergebnis;
wobei das Betriebsverfahren **dadurch gekennzeichnet ist, dass** das Verwalten der Lebensdauervorhersagefunktion das Korrigieren (S142) eines Werts von mindestens einem beliebigen Parameter der Lebensdauervorhersagefunktion umfasst, sodass das zweite Ergebnis einen Wert aufweist, der dem ersten Ergebnis entspricht, wobei der mindestens eine Parameter einen Koeffizienten von mindestens einem beliebigen von einem Ladezustand (SoC), einer konstanten Leistungsrate (CP-Rate) und einer Temperatur der Lebensdauervorhersagefunktion umfasst.

6. Betriebsverfahren nach Anspruch 5, wobei das Verwalten der Lebensdauervorhersagefunktion basierend auf dem ersten Ergebnis und dem zweiten Ergebnis umfasst:
Vergleichen (S141) einer Differenz zwischen dem zweiten Ergebnis und dem ersten Ergebnis mit einem Referenzwert.

7. Betriebsverfahren nach Anspruch 6, ferner umfassend das Aktualisieren (S143) der Lebensdauervorhersagefunktion, basierend auf dem Ergebnis des Vergleichens der Differenz mit dem Referenzwert.

## Revendications

1. Appareil de prédiction de durée de vie de batterie (120) comprenant :
une unité d'obtention de données (121) configurée pour obtenir des données de fonctionnement d'une batterie (110) ; et
un contrôleur (122) configuré pour :
prédire une durée de vie de la batterie sur la base d'une méthode d'intégration de courant en utilisant les données de fonctionnement pour générer un premier résultat,
prédire la durée de vie de la batterie sur la base d'une fonction de prédiction de durée de vie en utilisant les données de fonctionnement pour générer un deuxième résultat, et
gérer la fonction de prédiction de durée de vie sur la base du premier résultat et du deuxième résultat ;
ledit appareil de prédiction de durée de vie de batterie étant **caractérisé en ce que** le contrôleur est en outre configuré, pour gérer la fonction de prédiction de durée de vie, pour corriger une valeur d'au moins un quelconque paramètre de la fonction de prédiction de durée de vie de sorte que le deuxième résultat ait une valeur correspondant au premier résultat, ledit au moins un paramètre comprenant un coefficient d'au moins l'un quelconque d'un état de charge (SoC), d'un taux de puissance constant (taux CP), et d'une température de la fonction de prédiction de durée de vie.

2. L'appareil de prédiction de durée de vie de batterie selon la revendication 1, dans lequel le contrôleur est en outre configuré pour corriger ladite valeur de sorte qu'une différence entre le deuxième résultat et le premier résultat soit inférieure à une valeur de référence.

3. L'appareil de prédiction de durée de vie de batterie selon la revendication 1, dans lequel le contrôleur est en outre configuré pour mettre à jour la fonction de prédiction de durée de vie en utilisant la valeur de l'au moins un d'un état de charge (SoC), d'un taux de puissance constant (taux CP), et d'une température de la fonction de prédiction de durée de vie lorsqu'une différence entre le deuxième résultat et le premier résultat est inférieure à une valeur de référence.

4. L'appareil de prédiction de durée de vie de batterie selon la revendication 1, dans lequel le contrôleur est en outre configuré pour :
générer le premier résultat et le deuxième résultat sur la base des données de fonctionnement obtenues quotidiennement, et
gérer la fonction de prédiction de durée de vie sur la base du premier résultat et du deuxième résultat obtenus quotidiennement.

5. Procédé de fonctionnement d'un appareil de prédiction de durée de vie de batterie, le procédé de fonctionnement comprenant :
l'obtention (S110) de données de fonctionnement d'une batterie ;
la prédiction (S120) d'une durée de vie de la batterie sur la base d'une méthode d'intégration de courant en utilisant les données de fonctionnement pour générer un premier résultat ;
la prédiction (S130) de la durée de vie de la batterie sur la base d'une fonction de prédiction de durée de vie en utilisant les données de fonctionnement pour générer un deuxième résultat ; et
la gestion (S140) de la fonction de prédiction de durée de vie sur la base du premier résultat et du deuxième résultat ;
ledit procédé de fonctionnement étant **caractérisé en ce que** la gestion de la fonction de prédiction de durée de vie comprend la correction (S142) d'une valeur d'au moins un quelconque paramètre de la fonction de prédiction de durée de vie de sorte que le deuxième résultat ait une valeur correspondant au premier résultat, ledit au moins un paramètre comprenant un coefficient d'au moins l'un quelconque d'un état de charge (SoC), d'un taux de puissance constant (taux CP), et d'une température de la fonction de prédiction de durée de vie.

6. Le procédé de fonctionnement selon la revendication 5, dans lequel la gestion de la fonction de prédiction de durée de vie sur la base du premier résultat et du deuxième résultat comprend :
la comparaison (S141) d'une différence entre le deuxième résultat et le premier résultat avec une valeur de référence.

7. Le procédé de fonctionnement selon la revendication 6, comprenant en outre la mise à jour (S143) de la fonction de prédiction de durée de vie, sur la base du résultat de la comparaison de la différence avec la valeur de référence.
